Europäisches Patentamt

**European Patent Office**

Office européen des brevets

(11) Veröffentlichungsnummer: **0 144 693**
A2

(12) # EUROPÄISCHE PATENTANMELDUNG

(21) Anmeldenummer: 84112955.4

(22) Anmeldetag: 26.10.84

(51) Int. Cl.⁴: **H 05 K 9/00**

(30) Priorität: 03.11.83 DE 3339791

(43) Veröffentlichungstag der Anmeldung:
19.06.85 Patentblatt 85/25

(84) Benannte Vertragsstaaten:
DE GB

(71) Anmelder: Siemens Aktiengesellschaft
Berlin und München Wittelsbacherplatz 2
D-8000 München 2(DE)

(72) Erfinder: Kaiserswerth, Hans-Peter
Lessingstrasse 7b
D-8400 Regensburg(DE)

(54) Durchfluss - insbesondere Lüftungseinsatz für elektromagnetisch geschirmte Räume.

(57) Durchfluß- insbesondere Lüftungseinsatz für elektromagnetisch geschirmte Räume, insbesondere mit Blech oder Metallfolien ausgekleidete Kabinen, mit geringem Durchflußwiderstand und hoher Schirmdämpfung der aus porösem Sinterwerkstoff, insbesondere aus einem Metallfaservlies (9) miteinander versinterter Metallfasern (8) oder aus einem unterhalb seines Schmelzpunktes zu Platten gesinterten Metallpulver besteht.

FIG 3

EP 0 144 693 A2

0144693

Kreuzungs- und Berührungspunkte der Metalldrähte des Vlieses und des Drahtgewebes. Die Schirmdämpfung ist dabei abhängig von den Dicken des Vlieses und des Drahtgewebes. Mit abnehmender Dicke des Metallvlieses bei gleichbleibender Dicke des Drahtgewebes sinkt die Dämpfung. Die Dämpfung des in den Kreuzungspunkten gesinterten Drahtgewebes, dem kein Metallvlies aufgesintert ist, stellt folglich den Grenzfall dar. Denkbar ist daher auch ein Einsatz aus einem mindestens in seinen Kreuzungsstellen gesinterten Drahtgewebe, das mit einem an sich bekannten Wabenkamin-Einsatz zu einer Filtereinheit zusammengefaßt ist.

Die Erfindung wird nachstehend anhand der Zeichnung näher erläutert. Es zeigt:

Fig. 1 einen an sich bekannten Wabenkamineinsatz in teilweise gebrochener und perspektivischer Darstellung

Fig. 2 einen weiteren, an sich bekannten Wabenkamineinsatz, in der Darstellung nach Fig. 1

Fig. 3 ein Ausführungsbeispiel für einen Einsatz nach der Erfindung in Draufsicht, wobei zur Veranschaulichung Teile des Einsatzes entfernt sind

Fig. 4 die Schirmdämpfungs-Kurve für einen aus gesintertem Metallpulver gefertigten Einsatz

Fig. 5 die Schirmdämpfungs-Kurve für einen Wabenkamineinsatz nach Fig. 1 und 2 und für einen Einsatz der aus einem Metallfaservlies besteht.

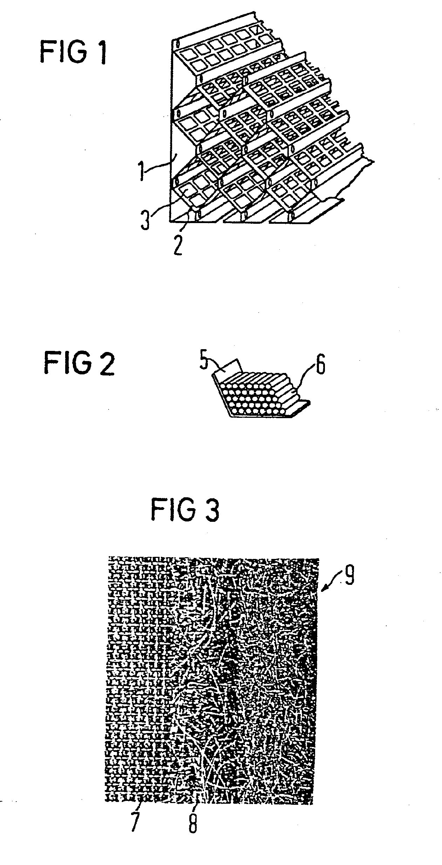

Bei dem für Frequenzen bis 1000 MHz geeigneten bekannten Wabenkamineinsatz nach Fig. 1 sind Blechelemente 2 rechteckigen Querschnitts zu einem Wabenmuster zusammengefügt. Die Blechelemente 2 sind mit Durchbrechungen 3

0144693

ausgebildet, weshalb auch schräg einfallendes Licht in den geschirmten Raum gelangen kann. Das Wabenmuster ist von einem Rahmen 1 begrenzt, mittels dem die Anordnung in die den geschirmten Raum umhüllende Kabinenwand eingelötet bzw. eingeschweißt werden kann.

Fig. 2 zeigt einen für Frequenzen größer 1000 MHz geeignetén, aus Hohlleitern 6 zusammengesetzten Wabenkamineinsatz, der durch einen Rahmen 5 begrenzt ist.

Der erfindungsgemäße Durchfluß-, insbesondere Lüftungseinsatz nach Fig. 3 besitzt ein Drahtgewebe 7, an das ein plattenförmiges Metallfaservlies 9 angesintert ist. Das Metallfaservlies 9 an sich ist aus einer Schicht miteinander versinterter Metallfasern 8 unorientierter Anordnung gebildet.

Dieser Einsatz kann - was in der Zeichnung nicht dargestellt ist - mit einem Wabenkamineinsatz üblicher Art zu einer Filtereinheit zusammengefaßt und zur Vermeidung seiner Verschmutzung zusätzlich mit einem auswechselbaren Papierfilter kombiniert sein.

Fig. 4 zeigt die über der Frequenz f aufgetragene Schirm-. dämpfung, gemessen in dB, für einen Lüftungseinsatz, der aus einer aus pulverförmigem Cr-Ni-Mo-Stahl gesinterten, 3 mm dicken Platte besteht, deren Filterfeinheit 3 µm beträgt.

Die Schirmdämpfung dieses Einsatzes erreicht bereits bei 10 kHz eine Schirmdämpfung, die 80 dB und ab 150 kHz die Meßgrenze von 140 dB übersteigt. Auch im Bereich von 1 bis 10 GHz überschreitet die Schirmdämpfung die frequenzabhängige Meßgrenze von 80/100 dB. Ein Metallfaservlies gemäß Fig. 3 der 1,5 mm dick ist, besitzt diese hohen Dämpfungswerte lediglich im Frequenzbereich $> 1$ GHz. Bei tieferen Frequenzen ist, wie dies die Kurve "c" nach Fig. 5 zeigt, die Dämpfung geringer. In diesem Bereich läßt sich aber durch Wabenkamin-Einsätze eine hohe Schirmdämpfung erreichen, wie ein Vergleich der Kurven "a" und "b" erkennen läßt, welche die Schirmdämpfung eines Wabenkamin-Einsatzes vom 1-GHz-Typ (siehe Fig. 1) bzw. vom 35-GHz-Typ (siehe Fig. 2) wiedergeben.

Die Kombination eines Metallfaservlieses mit einem Wabenkamin-Einsatz ergibt ein für Luft, Gase und Flüssigkeiten durchlässiges Dämpfungselement, das die hohe Schirmdämpfung eines Wabenkamin-Einsatzes mit der eines Metallfaservlieses vereinigt. Das für die erfindungsgemäßen Einsätze verwendete Material ist dabei in ausgezeichneter Weise für die Einführung von Gasen und Flüssigkeiten in geschirmte Räume geeignet, da es, so wie es angeboten wird, aus korrosionsbeständigen Werkstoffen besteht.

0144693

Patentansprüche

1. Durchfluß- insbesondere Lüftungseinsatz für elektromagnetisch geschirmte Räume, insbesondere mit Blech oder Metallfolien ausgekleidete Kabinen, der sich durch geringen Durchflußwiderstand für gasförmige Medien und Flüssigkeiten und hohe Schirmdämpfung auszeichnet, d a d u r c h   g e k e n n z e i c h n e t, daß der Einsatz aus porösem Sinterwerkstoff besteht.

2. Durchfluß- insbesondere Lüftungseinsatz nach Anspruch 1, g e k e n n z e i c h n e t   durch ein Metallfaservlies (9), bestehend aus einer Schicht miteinander versinterter Metallfasern (8) unorientierter Anordnung.

3. Durchfluß- insbesondere Lüftungseinsatz nach Anspruch 2, d a d u r c h   g e k e n n z e i c h n e t, daß an das insbesondere plattenförmige Metallfaservlies (9) einseitig ein Drahtgewebe (7) angesintert ist.

4. Durchfluß- insbesondere Lüftungseinsatz nach Anspruch 1, d a d u r c h   g e k e n n z e i c h n e t, daß der Sinterwerkstoff aus einem unterhalb seines Schmelzpunktes zu Platten gesinterten Metallpulver besteht.

5. Durchfluß- insbesondere Lüftungseinsatz nach Anspruch 1 bis 4, d a d u r c h   g e k e n n z e i c h n e t, daß der Lüftungseinsatz mit einem an sich bekannten Wabenkamin-Einsatz zu einer Filtereinheit zusammengefaßt ist.

6. Durchfluß- insbesondere Lüftungseinsatz nach Anspruch 1 bis 5, d a d u r c h g e k e n n z e i c h n e t, daß der Einsatz mit einem auswechselbaren Papierfilter kombiniert ist.

7. Durchfluß- insbesondere Lüftungseinsatz nach Anspruch 1, d a d u r c h  g e k e n n z e i c h n e t, daß der Einsatz aus einem mindestens in seinen Kreuzungsstellen gesinterten Drahtgewebe besteht, das mit einem an sich bekannten Wabenkamin-Einsatz zu einer Filterein- heit zusammengefaßt ist.

FIG 1

1
3
2

FIG 2

5
6

FIG 3

9

7    8